# EUROPEAN PATENT APPLICATION

(11) **EP 2 978 282 A1**
(43) Date of publication of application: **27.01.2016**
(21) Application number: 14770316.9
(22) Date of filing: 11.03.2014
(51) Int. Cl.: H05B 33/10, B65H 23/185, H01L 51/50, H05B 33/02, H05B 33/04

(54) **METHOD FOR PRODUCING ORGANIC ELECTROLUMINESCENT DEVICES**

(30) Priority: 22.03.2013 JP 2013059612
(71) Applicant: Nitto Denko Corporation, Ibaraki-shi, Osaka 567-8680 (JP)
(72) Inventor: OSAKI Yoshinori, Ibaraki-shi Osaka 567-8680 (JP); YAMAMOTO Satoru, Ibaraki-shi Osaka 567-8680 (JP); KOMOTO Yusuke, Ibaraki-shi Osaka 567-8680 (JP); SOGA Masatsugu, Ibaraki-shi Osaka 567-8680 (JP)
(74) Representative: Grünecker Patent- und Rechtsanwälte PartG mbB
(86) International application number: PCT/JP2014/056292
(87) International publication number: WO 2014/148305

(57) **Abstract**

A method for producing an organic electroluminescence device using a roll-to-roll method includes the step of sticking a belt-shaped sealing substrate 5 transported while being applied with tension on a belt-shaped supporting substrate 21 on which an organic electroluminescence element is formed, wherein either one substrate of the supporting substrate 21 or the sealing substrate 5 has a tensile modulus of elasticity larger than that of another substrate, in the step, the sticking is performed in the middle of transporting the belt-shaped supporting substrate 21 in the long-side direction while being applied with tension, and in the step, the substrate having a smaller tensile modulus of elasticity is applied with tension less than or equal to 170 N/m and the substrate having a larger tensile modulus of elasticity is applied with tension greater than the tension applied to the substrate having a smaller tensile modulus of elasticity.

## Description

### TECHNICAL FIELD

The present invention relates to a method for producing organic electroluminescence device.

### BACKGROUND ART

Hereinafter, the organic electroluminescence is referred to as the "organic EL".

An organic EL device having a supporting substrate, an organic EL element provided on the supporting substrate, and a sealing substrate provided on the organic EL element has hitherto been known. The organic EL element has a first electrode, a second electrode, and an organic layer provided between the both electrodes.

As a production method of the organic EL device, a roll-to-roll method has been known.

For example, the production method using a roll-to-roll method includes the step of feeding out a belt-shaped supporting substrate wound into a roll, the step of forming a plurality of organic EL elements on the belt-shaped supporting substrate, the step of sticking a belt-shaped sealing substrate on the plurality of organic EL elements via an adhesive layer, and the winding step of winding a belt-shaped laminated body having the supporting substrate, the organic EL elements and the sealing substrate into a roll (Patent Document 1).

In the roll-to-roll method, by laminating a belt-shaped sealing substrate transported while being applied with tension on a belt-shaped supporting substrate in the middle of transporting the belt-shaped supporting substrate in the long-side direction while applying tension to the belt-shaped supporting substrate on which a plurality of organic EL elements is formed, and sticking the sealing substrate on the supporting substrate, an organic EL device in which the supporting substrate, the organic EL element and the sealing substrate are laminated in this order is obtained.

Incidentally, as the supporting substrate and the sealing substrate, various substrates are used. For example, as the supporting substrate and the sealing substrate, substrates differing in the tensile modulus of elasticity from each other are sometimes used.

However, when the substrates differing in the tensile modulus of elasticity from each other are transported while being applied with tension using a roll-to-roll method, as a result of allowing respective substrates to differ in the deformation amount of the base material, the internal stress of the substrate is increased. For this reason, there is a problem that the organic EL element is damaged or the sealing substrate peels off. Moreover, since there is a possibility that the obtained organic EL device is curved, the handling for the storage of the organic EL device, the transportation and processing, and the like becomes complicated.

[Patent Document 1] JP 2010-097803 A

### SUMMARY OF THE INVENTION

An object of the present invention is to provide a method for producing an organic EL device which is hardly curved and excellent in durability using a roll-to-roll method.

A first method for producing an organic EL device using a roll-to-roll method includes the step of sticking a belt-shaped sealing substrate transported while being applied with tension on a belt-shaped supporting substrate on which an organic electroluminescence element is formed, wherein either one substrate of the supporting substrate or the sealing substrate has a tensile modulus of elasticity larger than that of another substrate, in the step, the sticking is performed in the middle of transporting the belt-shaped supporting substrate in the long-side direction while being applied with tension, and in the step, the substrate having a smaller tensile modulus of elasticity is applied with tension less than or equal to 170 N/m and the substrate having a larger tensile modulus of elasticity is applied with tension greater than the tension applied to the substrate having a smaller tensile modulus of elasticity.

A second method for producing an organic electroluminescence device using a roll-to-roll method includes the step of sticking a belt-shaped sealing substrate transported while being applied with tension on a belt-shaped supporting substrate on which an organic electroluminescence element is formed, wherein either one substrate of the supporting substrate or the sealing substrate has a tensile modulus of elasticity larger than that of another substrate, in the step, the sticking is performed in the middle of transporting the belt-shaped supporting substrate in the long-side direction while being applied with tension, and in the step, the substrate having a smaller tensile modulus of elasticity is applied with tension (N/m) having a numerical value less than or equal to 43 times the numerical value of its tensile modulus of elasticity (GPa) and the substrate having a larger tensile modulus of elasticity is applied with tension greater than the tension applied to the substrate having a smaller tensile modulus of elasticity.

In a preferable organic EL device of the present invention, the tension applied to the substrate having a larger tensile modulus of elasticity is greater than or equal to 200 N/m.

In a preferable organic EL device of the present invention, a difference in tensile modulus of elasticity between the supporting substrate and the sealing substrate is greater than or equal to 30 GPa.

In a preferable method for producing organic EL device of the present invention, the supporting substrate is the substrate having a larger tensile modulus of elasticity and the sealing substrate is the substrate having a smaller tensile modulus of elasticity.

In another preferable method for producing organic EL device of the present invention, the supporting substrate is the substrate having a smaller tensile modulus of elasticity and the sealing substrate is the substrate having a larger tensile modulus of elasticity.

In another preferable method for producing organic EL device of the present invention, the substrate having a larger tensile modulus of elasticity contains a metal sheet and the substrate having a smaller tensile modulus of elasticity contains a resin sheet.

In another preferable method for producing organic EL device of the present invention, the substrate having a larger tensile modulus of elasticity contains a glass sheet and the substrate having a smaller tensile modulus of elasticity contains a resin sheet.

Preferably, a barrier layer is laminated on the resin sheet.

In another preferable organic EL device of the present invention, the sealing substrate is stuck on the supporting substrate via an adhesive layer.

According to the method for producing an organic EL device of the present invention, it is possible to obtain an organic EL device which is hardly curved and excellent in durability. In this organic EL device, the sealing substrate hardly peels off, and moreover, the organic EL element is hardly damaged. The organic EL device according to the present invention has a relatively long life, and moreover, the handling does not become complicated.

### BRIEF DESCRIPTION OF THE DRAWINGS

Fig. 1 is a plan view of an organic EL device according to one embodiment of the present invention.
Fig. 2 is an enlarged sectional view taken along the line II-II in Fig. 1 (an enlarged sectional view taken in the thickness direction of an organic EL device).
Fig. 3 is an enlarged sectional view taken in the thickness direction of an organic EL device according to another embodiment of the present invention.
Fig. 4 is a plan view of a sheet-like organic EL device.
Fig. 5 is a schematic view of a device used in the production method according to one embodiment of the present invention.
Fig. 6 is a sectional view taken along the line VI-VI in Fig. 5.

### DESCRIPTION OF THE EMBODIMENTS

Hereinafter, the present invention will be described with reference to the drawings. It should be noted that dimensions such as a thickness and a length in the drawings are different from actual dimensions.

In this specification, the terms "first" and "second" may be added as prefixes. These prefixes, however, are only added in order to distinguish the terms and do not have specific meaning such as order and relative merits. The "belt-shaped" means a substantially rectangular shape in which a length in one direction is sufficiently larger than a length in the other direction. The "belt-shaped" is a substantially rectangular shape in which a length in one direction is greater than or equal to 10 times, preferably greater than or equal to 30 times, more preferably greater than or equal to 100 times of a length in the other direction. The "long-side direction" is one direction of the belt shape (direction parallel to the longer side of the belt shape), and the "short-side direction" is the other direction of the belt shape (direction parallel to the shorter side of the belt shape). The wording "PPP to QQQ" indicates "greater than or equal to PPP and less than or equal to QQQ".

### [Configuration of organic EL device]

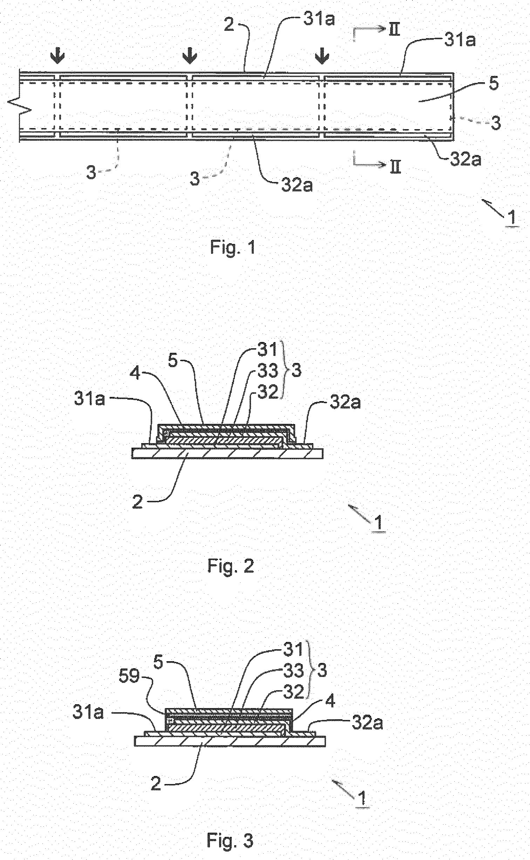

As illustrated in Fig. 1 and Fig. 2, an organic EL device 1 of the present invention has a belt-shaped supporting substrate 2, an organic EL element 3 provided on the belt-shaped supporting substrate 2, and a belt-shaped sealing substrate 5 stuck on the organic EL element 3 via an adhesive layer 4. A plurality of the organic EL elements 3 are arranged at required intervals in the long-side direction of the belt-shaped supporting substrate 2.

The organic EL element 3 has a first electrode 31 with a terminal 31a, a second electrode 32 with a terminal 32a, and an organic layer 33 provided between the both electrodes 31, 32.

In the organic EL element 3, using the organic layer 33 as a basis, the terminal 31a of the first electrode 31 is provided on a first side and the terminal 32a of the second electrode 32 is provided on a second side. The first side and the second side are mutually opposite sides, and for example, the first side is one side in the short-side direction of the supporting substrate 2 and the second side is the other side in the short-side direction of the supporting substrate 2.

The belt-shaped sealing substrate 5 is laminated on and bonded to the surface of the supporting substrate 2 so as to cover the surface of the organic EL element 3 excluding these terminals 31a, 32a.

As illustrated in Fig. 2, a layer configuration of the organic EL device 1 includes the belt-shaped supporting substrate 2, the first electrode 31 provided on the belt-shaped supporting substrate 2, the organic layer 33 provided on the first electrode 31, the second electrode 32 provided on the organic layer 33, and the sealing substrate 5 provided on the second electrode 32.

When the supporting substrate 2 has electric conductivity, an insulating layer (not illustrated) is provided between the supporting substrate 2 and the first electrode 31 in order to prevent an electrical short-circuit.

For example, the organic EL element 3 is formed in a substantially rectangular planar shape. Of course, the planar shape of the organic EL element 3 is not limited to a substantially rectangular shape, and for example, may be formed in a substantially square shape, a circular shape, or the like.

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is provided on the surface of the first electrode 31, exclusive of the end portion (terminal 31a) of the first electrode 31 on the first side.

The second electrode 32 is provided on the surface of the organic layer 33 so as to cover a surface of the organic layer 33. For forming the terminal 32a of the second electrode 32, the end portion of the second electrode 32 is drawn from the end portion of the organic layer 33 to the second side.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

The sealing substrate 5 is bonded onto the surface of the organic EL element 3 (second electrode 32) via the adhesive layer 4 so as not to cover respective terminals 31a, 32a of the first electrode 31 and the second electrode 32.

The sealing substrate 5 is a layer for preventing oxygen, water vapor and the like from entering the organic EL element 3.

The sealing substrate 5 airtightly covers the whole part of the organic EL element 3 excluding the respective terminals 31a, 32a. For details, the sealing substrate 5 is bonded onto the surface of the second electrode 32 via the adhesive layer 4 excluding the respective terminals 31a, 32a, and furthermore, as illustrated in Fig. 2, the sealing substrate 5 is bonded to the peripheral end face of the organic EL element 3. Moreover, the peripheral edge parts of the sealing substrate 5 each are bonded to the surface of the supporting substrate 2, the surface of the first electrode 31 and the surface of the second electrode 32.

As illustrated in Fig. 3, as necessary, a barrier layer 59 may be laminated on the rear face of the sealing substrate 5. The rear face of the sealing substrate 5 is a face opposite the organic EL element 3. Accordingly, the barrier layer 59 is interposed between the sealing substrate 5 and the second electrode 32.

Moreover, although the sealing substrate 5 is bonded to the peripheral end face of the organic EL element 3 in an example illustrated in Fig. 2, for example, as illustrated in Fig. 3, the sealing substrate 5 may be bonded so as not to cover the peripheral end face of the organic EL element 3 (in this case, the sealing substrate 5 is bonded only to a surface side of the organic EL element 3).

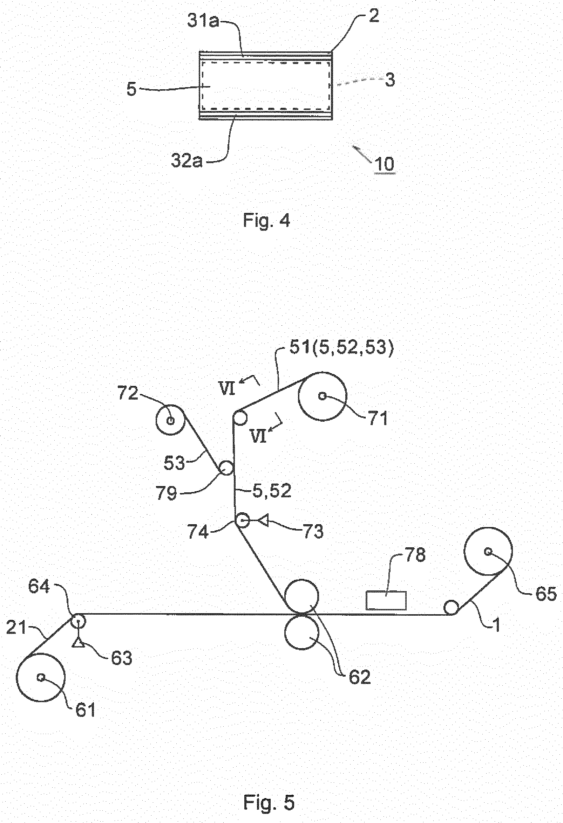

The belt-shaped organic EL device 1 is appropriately cut at the boundary part between adjacent organic EL elements 3 at the time of using. In Fig. 1, cutting portions are shown by arrows. By processing the belt-shaped organic EL device 1 as described above, a sheet-like organic EL device 10 illustrated in Fig. 4 is obtained.

The organic EL devices 1, 10 can be used alone or in combination of plural kinds thereof to be utilized as a light emitting panel for lighting equipment, an image display, or the like.

Hereinafter, the forming materials for the organic EL device, the production method, and the like will be described in detail.

### [Supporting substrate and sealing substrate]

Either of the belt-shaped supporting substrate and the belt-shaped sealing substrate is a flexible sheet-shaped object. Although the length (length in the long-side direction) of each of the belt-shaped supporting substrate and the sealing substrate is not particularly limited, for example, the length lies within the range of 10 m to 1000 m. Moreover, although the width (length in the short-side direction) of the supporting substrate is not also particularly limited, for example, the width lies within the range of 10 mm to 300 mm, and preferably lies within the range of 10 mm to 100 mm. Since the organic EL device 1 illustrated in Fig. 1 allows the terminals 31a, 32a to be arranged at both sides in the short-side direction of the supporting substrate 2, the width of the sealing substrate 5 is slightly shorter than the width of the supporting substrate 2.

With regard to the supporting substrate and the sealing substrate, provided that both substrates are not opaque, one substrate may be transparent and the other substrate may be opaque, or both substrates may be transparent. In this connection, being transparent refers to being colorless transparent or being colored transparent. The index of transparency may be, for example, a total light transmittance of greater than or equal to 70%, preferably greater than or equal to 80%. It is to be noted that the total light transmittance is a value measured by a measurement method conforming to JIS K7105 (Method of Testing Optical Characteristics of Plastics). When a bottom emission type organic EL device is formed, a transparent supporting substrate is used. When a top emission type organic EL device is formed, a transparent sealing substrate is used.

In the present invention, provided that the supporting substrate and the sealing substrate are substrates differing in the tensile modulus of elasticity from each other, the material quality, the thickness and the like are not particularly limited.

For example, the supporting substrate may be a substrate having a larger tensile modulus of elasticity than that of the sealing substrate (in this case, the sealing substrate is a substrate having a smaller tensile modulus of elasticity). Alternatively, the supporting substrate may be a substrate having a smaller tensile modulus of elasticity than that of the sealing substrate (in this case, the sealing substrate is a substrate having a larger tensile modulus of elasticity).

Hereinafter, in the present specification, a substrate having a larger tensile modulus of elasticity is sometimes described as "a large elasticity substrate", and a substrate having a smaller tensile modulus of elasticity than that of the large elasticity substrate is sometimes described as "a small elasticity substrate".

For example, the tensile modulus of elasticity of the large elasticity substrate is 3 times to 4000 times, preferably 5 times to 300 times, and more preferably 10 times to 100 times the tensile modulus of elasticity of the small elasticity substrate.

Moreover, although the tensile modulus of elasticity of the large elasticity substrate is not particularly limited, for example, the tensile modulus of elasticity is 30 GPa to 400 GPa, preferably 40 GPa to 350 GPa, and more preferably 50 GPa to 300 GPa.

Although the tensile modulus of elasticity of the small elasticity substrate is not particularly limited, for example, the tensile modulus of elasticity is 0.1 GPa to 30 GPa, preferably 1 GPa to 20 GPa, and more preferably 2 GPa to 10 GPa.

Although a difference between the tensile modulus of elasticity of the large elasticity substrate and the tensile modulus of elasticity of the small elasticity substrate (the large elasticity substrate - the small elasticity substrate) is not particularly limited, for example, it is greater than or equal to 30 GPa, preferably greater than or equal to 50 GPa, and more preferably greater than or equal to 120 GPa.

In this context, for example, with regard to a substrate of a metallic material, the tensile modulus of elasticity can be measured according to JIS Z 2280 (Test method for Young's modulus of metallic materials at elevated temperature), and with regard to a substrate of a resin material, the tensile modulus of elasticity can be measured according to JIS K 7127 (Plastics-Determination of tensile properties).

As the supporting substrate or the sealing substrate, for example, a metal sheet, a resin sheet, a glass sheet, a ceramic sheet, a laminated sheet in which a resin layer is laminated on a metal sheet, a glass sheet or the like, and the like can be appropriately selected to be used. In the present specification, a sheet includes one generally called a film.

Although the metal sheet is not particularly limited, examples thereof include flexible thin plates composed of stainless steel, copper, titanium, aluminum, an alloy, and the like. For example, the thickness of the metal sheet lies within the range of 10 µm to 100 µm.

Although the resin sheet is not particularly limited, examples thereof include flexible synthetic resin sheets such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). A thickness of the resin sheet is not particularly limited, but it is 10 µm to 200 µm, for example.

In general, respective tensile moduli of elasticity of the metal sheet, the resin sheet and the glass sheet satisfy the equation of the tensile modulus of elasticity of the metal sheet > the tensile modulus of elasticity of the glass sheet > the tensile modulus of elasticity of the resin sheet.

For preventing a rise in temperature of the organic EL device at the time of driving, the supporting substrate and the sealing substrate are preferably excellent in heat dissipation. Furthermore, for preventing oxygen, water vapor and the like from entering the organic EL element, the supporting substrate and the sealing substrate preferably has gas and water vapor barrier properties. The above mentioned barrier layer may be laminated on at least one face of the resin sheet to impart such barrier properties. While a forming material for the barrier layer is not particularly limited, but examples include a metal oxide film, an oxynitride film, a nitride film, and a carbide nitride oxide film. Examples of the metal oxide film include MgO, SiO, SiₓO_{y}, Al₂O₃, GeO, and TiO₂. The barrier layer is preferably a silicon carbide nitride oxide film (SiOCN), a silicon oxynitride film (SiON), and a silicon nitride film (SiN). A thickness of the barrier layer is not particularly limited, but it is 50 nm to 10 µm, for example.

In the case where conductive substrates (metal sheets or the like) are used as the supporting substrate and the sealing substrate, in order to insulate the conductive substrate from an electrode opposite the conductive substrate, an insulating layer is provided on the front face of the supporting substrate or the rear face of the sealing substrate.

In one preferred embodiment, as the supporting substrate, a metal sheet such as a stainless steel thin plate (as described above, a metal sheet on which an insulating layer is provided on the surface) is used, and as the sealing substrate, a resin sheet such as a polyethylene terephthalate sheet (preferably, a resin sheet on which a barrier layer is laminated) or a glass sheet such as a glass plate on both faces of which synthetic resin layers are provided respectively is used.

In another preferred embodiment, as the supporting substrate, a resin sheet such as a polyethylene terephthalate sheet (preferably, a resin sheet on which a barrier layer is laminated) or a glass sheet on both faces of which synthetic resin layers are provided respectively is used, and as the sealing substrate, a metal sheet such as a stainless steel thin plate (as described above, a metal sheet on the rear face of which an insulating layer is provided) is used.

In order to impart the metal sheet and the resin sheet with desired functions, optional layers may be laminated on those sheets respectively.

### [Organic EL Element having First Electrode, Organic Layer, and Second Electrode]

A first electrode is an anode, for example.

The formation material of the first electrode (anode) is not particularly limited, but examples include indium tin oxide (ITO); indium tin oxide including silicon oxide (ITSO); aluminum; gold; platinum; nickel; tungsten; copper; and an alloy. When a bottom emission type organic EL device is formed, a transparent first electrode is used.

A thickness of the first electrode is not particularly limited, but it is usually 0.01 µm to 1.0 µm.

An organic layer has a laminated structure composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a positive hole transport layer.

The organic layer used in the present invention can have any of the structures (A) to (C) mentioned above.

The organic layer having the structure (A) is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer may be provided on the surface of the first electrode, and the positive hole transport layer may be provided on the surface of the positive hole injection layer. The positive hole injection layer is a layer having a function of aiding injection of a positive hole from the anode layer to the positive hole transport layer.

A formation material of the positive hole transport layer is not particularly limited as long as the formation material has a positive hole transport function. Examples of the formation material for the positive hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis{naphthalene-1-yl}-N,N'-bis(phenyl)-9,9'-spiro-bisfluorene (abbreviation: Spiro-NPB); a polymer compound; and the like. The formation material of the positive hole transport layer may be used alone or in combination of two or more formation materials. Furthermore, the positive hole transport layer may be a multi-layer structure having two or more layers.

A thickness of the positive hole transport layer is not particularly limited, but the thickness of 1 nm to 500 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (Alq₃), and the like.

Furthermore, as the formation material for the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6'bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emitting layer may include such as the formation material of the positive hole transport layer mentioned above, the formation material of the electron transport layer mentioned below, and various additives.

A thickness of the light emitting layer is not particularly limited, but the thickness of 2 nm to 500 nm is preferable, for example.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer may be provided on the surface of the electron transport layer, and the second electrode is provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used alone or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage.

A second electrode is a cathode, for example.

A formation material of the second electrode is not particularly limited, but a transparent second electrode is used when a top emission type organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, but it is usually 0.01 µm to 1.0 µm.

### [Method for producing organic EL device]

The method for producing an organic EL device according to the present invention includes the element-forming step of forming a plurality of organic EL elements on a belt-shaped supporting substrate, the laminating step of sticking a flexible belt-shaped sealing substrate on the belt-shaped supporting substrate while including the plurality of organic EL elements, and the winding step of winding a belt-shaped laminated body having the belt-shaped supporting substrate, the organic EL elements and the sealing substrate into a roll.

In the method for producing an organic EL device, although at least the above-mentioned laminating step is performed using a roll-to-roll method, throughout the element-forming step and the laminating step, a roll-to-roll method may be used.

### (Element-forming step)

The forming step of an organic EL element is performed in the same manner as that for a conventional one.

In a brief description, a belt-shaped supporting substrate wound into a roll is fed out, and the supporting substrate is washed in a washing tub and dried, as necessary. After being washed and dried, a first electrode is formed on the surface of the supporting substrate.

As the formation method of the first electrode, an optimum method can be employed depending on the formation material, and examples of the method include a sputtering method, a vapor deposition method, an ink-jet method, and the like. For example, in the case of forming a positive electrode using a metal, a vapor deposition method is used. A supporting substrate on which a first electrode is previously patterned may be used. In the case of using the supporting substrate on which a first electrode is previously formed, the substrate is fed out, and is washed and dried.

An organic layer is formed on the surface of the first electrode, exclusive of a terminal thereof. On the surface of the first electrode, a positive hole transport layer, a light emitting layer, and an electron transport layer can be formed in this order to form an organic layer, for example. As the formation method of the positive hole transport layer and the electron transport layer, an optimum method can be employed depending on the formation material, and examples of the method include a sputtering method, a vapor deposition method, an ink-jet method, a coating method, and the like. As the formation method of the light emitting layer, an optimum method can be employed depending on the formation material, but usually it is formed by a vapor deposition method.

Subsequently, the second electrode is formed on the surface of the organic layer. The second electrode is formed so as not to cover the terminal of the first electrode. As the formation method of the second electrode, an optimum method can be employed depending on the formation material, and examples of the method include a sputtering method, a vapor deposition method, an ink-jet method, and the like.

In this way, in the long-side direction of the belt-shaped supporting substrate, a plurality of organic EL elements are sequentially formed at required intervals. A barrier layer may be provided on the surface of the second electrode, as necessary.

The intervals between the plural organic EL elements are not particularly limited and can be appropriately set. For example, the interval lies within the range of 0.5 mm to 5 mm.

The obtained supporting substrate on which the organic EL element is formed (hereinafter, referred to as an element-formed supporting substrate) is wound into a roll so that the organic EL element faces outward, as necessary.

### (Laminating step)

The laminating step is the step of sticking a belt-shaped sealing substrate transported while being applied with tension on the belt-shaped element-formed supporting substrate in the middle of transporting the belt-shaped element-formed supporting substrate in the long-side direction while applying tension to the belt-shaped element-formed supporting substrate.

In Fig. 5, an element-formed supporting substrate 21 is wound around a roller 61. This roller 61 is provided with a drive motor (not illustrated), and by means of the motor for driving, the element-formed supporting substrate 21 is transported. This element-formed supporting substrate 21 is fed out from the roller 61, and the substrate is transported along the long-side direction thereof in the line. In the middle part of the line, nip rollers for lamination 62, 62 with which a sealing substrate 5 is stuck and pressed onto the element-formed supporting substrate 21 are provided. The element-formed supporting substrate 21 is passed through a gap between the nip rollers for lamination 62, 62 together with the sealing substrate 5.

Moreover, into the route between the roller 61 and the nip roller for lamination 62, a first tension detecting roller 64 equipped with a sensor 63 detecting the tension of the element-formed supporting substrate 21 transported is provided. By the first tension detecting roller 64, the tension applied to the element-formed supporting substrate 21 at the time when the sealing substrate 5 is laminated is detected. The detected tension value detected by the first tension detecting roller 64 is sent to a control part (not illustrated). The control part adjusts the rotating speed of the motor of the roller 61 so that the value of tension applied to the element-formed supporting substrate 21 becomes a value near the preset value.

Moreover, the sealing substrate 5 is wound around a roller 71. This roller 71 is provided with a drive motor (not illustrated), and by means of the motor for driving, the sealing substrate is transported to the nip roller for lamination 62.

On the rear face of the sealing substrate 5 before introduced to the nip roller for lamination 62, an uncured adhesive layer 52 for bonding the sealing substrate 5 to the element-formed supporting substrate 21 is provided.

In the present embodiment, a sealing substrate with a separator 51 in which the uncured adhesive layer 52 is previously coated on the rear face of the sealing substrate 5 and the adhesive layer is temporarily stuck to a separator 53 is used.

Accordingly, in the present embodiment, the sealing substrate with a separator 51 composed of the sealing substrate 5, the uncured adhesive layer 52 and the separator 53 is wound around the roller 71.

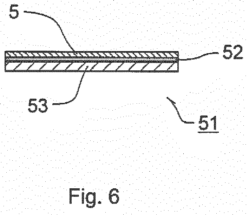

Fig. 6 is a sectional view of the sealing substrate with a separator 51. In Fig. 6, on the rear face of the sealing substrate 5, the uncured adhesive layer 52 is coated. On the sealing substrate 5, a barrier layer may be laminated (not illustrated in Fig. 6). By temporarily sticking the uncured adhesive layer 52 to a belt-shaped separator 53, the separator 53, the adhesive layer 52 and the sealing substrate 5 are laminated to constitute the sealing substrate with a separator 51. As the separator 53, a belt-shaped sheet-shaped object with a surface subjected to a release treatment is used so as to be easily peeled off from the uncured adhesive layer 52.

As an adhesive agent constituting the adhesive layer 52, a thermosetting type or photosetting type adhesive agent can be used. Examples of the thermosetting type adhesive agent include adhesive agents composed mainly of an epoxy resin, a phenol resin, a polyurethane resin, a melamine resin, and the like. As the photosetting type adhesive agent, representatively, an ultraviolet ray curable type adhesive agent can be used. Examples of the ultraviolet ray curable type adhesive agent include adhesive agents composed mainly of an ultraviolet ray curable acrylic resin, an ultraviolet ray curable urethane acrylate resin, an ultraviolet ray curable polyester acrylate resin, an ultraviolet ray curable polyurethane resin, an ultraviolet ray curable epoxy acrylate resin, an ultraviolet ray curable imide acrylate resin, and the like. For example, the thickness of the adhesive layer lies within the range of 5 µm to 100 µm.

The sealing substrate with a separator 51 is fed out from the roller 71. Before the sealing substrate 5 is introduced to the nip roller for lamination 62, only the separator 53 is turned from the sealing substrate with a separator 51 around a reverse roller 79 to peel off the separator. The separator 53 peeled off is recovered by a recovery roller 72. By peeling off the separator 53, the uncured adhesive layer 52 provided on the sealing substrate 5 is exposed.

Moreover, into the route between the reverse roller 79 and the nip roller for lamination 62, a second tension detecting roller 74 equipped with a sensor 73 detecting the tension of the sealing substrate 5 transported is provided. By the second tension detecting roller 74, the tension applied to the sealing substrate 5 at the time when the element-formed supporting substrate 21 is laminated is detected. The detected tension value detected by the second tension detecting roller 74 is sent to a control part (not illustrated). The control part adjusts the rotating speed of the motor of the roller 71 so that the value of tension applied to the sealing substrate 5 becomes a value near the preset value.

By introducing the element-formed supporting substrate 21 and the sealing substrate 5 which are separately transported while being applied with tension to a gap between the nip rollers for lamination 62, 62, the rear face of the sealing substrate 5 is stuck to the element-formed supporting substrate 21 via the uncured adhesive layer 52.

In the laminating step, while a small elasticity substrate is applied with tension less than or equal to 170 N/m and a large elasticity substrate is applied with tension greater than the tension applied to the small elasticity substrate, respective substrates are transported.

For example, in the case where a substrate having a larger tensile modulus of elasticity than that of the sealing substrate 5 is used as the supporting substrate 2 (in the case where the supporting substrate 2 is a large elasticity substrate likewise in this case, the sealing substrate 5 is a small elasticity substrate), the tension applied to the element-formed supporting substrate 21 is set so as to become greater than the tension applied to the sealing substrate 5, and the tension applied to the sealing substrate 5 is set to tension less than or equal to 170 N/m.

On the other hand, in the case where a substrate having a smaller tensile modulus of elasticity than that of the sealing substrate 5 is used as the supporting substrate 2 (in the case where the supporting substrate 2 is a small elasticity substrate likewise in this case, the sealing substrate 5 is a large elasticity substrate), the tension applied to the element-formed supporting substrate 21 is set to tension less than or equal to 170 N/m, and the tension applied to the sealing substrate 5 is set so as to become greater than the tension applied to the element-formed supporting substrate 21.

The tension applied to the small elasticity substrate is preferably set to tension less than or equal to 160 N/m, more preferably set to tension less than or equal to 150 N/m, and particularly preferably set to tension less than or equal to 120 N/m. The lower limit of the tension applied to the small elasticity substrate is not particularly limited, is theoretically greater than zero, and is preferably greater than or equal to 5 N/m.

Moreover, with regard to the tension applied to the small elasticity substrate, it is preferred that the small elasticity substrate be applied with tension (N/m) having a numerical value less than or equal to 43 times the numerical value of the tensile modulus of elasticity (GPa) of the small elasticity substrate, furthermore, it is more preferred that the small elasticity substrate be applied with tension having a numerical value less than or equal to 30 times the numerical value of its modulus of elasticity, and it is particularly preferred that the small elasticity substrate be applied with tension having a numerical value less than or equal to 28 times the numerical value of its modulus of elasticity. For example, in the case where the tensile modulus of elasticity of the small elasticity substrate is 4 GPa, the tension applied to the small elasticity substrate is less than or equal to about 170 N/m (less than or equal to 4 x 43 times), as described above.

On the other hand, provided that the tension applied to the large elasticity substrate is greater than the tension applied to the small elasticity substrate, the tension applied to the large elasticity substrate is not particularly limited. The tension applied to the large elasticity substrate is preferably greater than or equal to 200 N/m, more preferably greater than or equal to 230 N/m, and particularly preferably greater than or equal to 250 N/m. The upper limit of the tension applied to the large elasticity substrate is not particularly limited, is theoretically increased to the extent that the substrate is not broken, and for example, is less than or equal to 1500 N/m.

The tension applied to the element-formed supporting substrate 21 is detected by the first tension detecting roller 64, as described above, and the tension corresponds to tension between the roller 64 and the nip roller for lamination 62. The tension applied to the sealing substrate 5 is detected by the second tension detecting roller 74, as described above, and the tension corresponds to tension between the roller 74 and the nip roller for lamination 62.

At the downstream side of the nip roller for lamination 62, an adhesive agent curing device 78 is provided in order to cure the adhesive layer 52. The adhesive agent curing device 78 is appropriately selected according to the kind of the adhesive agent constituting the adhesive layer. In the case where the adhesive agent is a thermosetting type adhesive agent, as the curing device 78, a heating device is used. In the case where the adhesive agent is a photosetting type adhesive agent, as the curing device 78, a light irradiation device such as an ultraviolet ray irradiation device is used.

By curing the adhesive layer, the belt-shaped organic EL device 1 illustrated in Fig. 1 is obtained.

### (Winding step)

The belt-shaped organic EL device 1 is wound around a roller 65.

According to the production method of the present invention, while the large elasticity substrate is pulled with large force and the small elasticity substrate is pulled with force less than or equal to 170 N/m, which is smaller than the large force, both substrates are laminated and bonded to each other. Consequently, the difference in distortion between both substrates (the supporting substrate and the sealing substrate) does not become large, and it is thought that the internal stresses of both substrates become relatively small after the tension is released. Thus, the organic EL device obtained by the production method is hardly curved and is kept in a substantially flat state.

In the organic EL device, the sealing substrate hardly peels off, and moreover, the organic EL element is hardly damaged. Such an organic EL device can emit light for a relatively long period of time.

### [Another embodiment of method for producing organic EL device]

The production method of the present invention is not limited to the foregoing embodiment, and the design can be variously changed within the scope intended by the present invention.

In the production method of the foregoing embodiment, although the element-formed supporting substrate is once wound and then the supporting substrate is fed out again to perform the laminating step, the procedure is not limited thereto. For example, after the element-forming step, subsequently, the laminating step may be performed (without winding the element-formed supporting substrate) (not illustrated).

Furthermore, in the production method of the foregoing embodiment, although the sealing substrate with a separator is used, a sealing substrate may be used without being temporarily stuck to the separator. In this case, when an uncured adhesive layer is previously coated on the sealing substrate, the sealing substrate wound into a roll causes blocking. Consequently, it is preferred that only a sealing substrate be wound around a roller and an uncured adhesive agent be coated on the rear face of the sealing substrate just before the sealing substrate is introduced to the nip roller for lamination.

Moreover, in the production method of the foregoing embodiment, the adhesive layer is cured and then the belt-shaped organic EL device is wound, but instead of this, the belt-shaped organic EL device may be wound before the adhesive layer is cured and then the uncured adhesive layer may be cured.

### EXAMPLES

Hereinafter, the present invention will be described in more detail with reference to examples and comparative examples. However, the present invention should not be limited to the following examples.

### [Substrate used]

### (A) Metal sheet-containing substrate

As a metal sheet-containing substrate, one prepared by laminating an insulating layer with a thickness of 3 µm on a sheet of SUS304 foil (available from TOYO SEIHAKU CO., LTD.) with a thickness of 50 µm was used. Using an acrylic resin (available from JSR Corporation, trade name "JEM-477"), the resin was coated on one face of the sheet of the stainless steel foil to form the insulating layer.

### (B) Metal sheet substrate

As a metal sheet substrate, a sheet of SUS304 foil (available from TOYO SEIHAKU CO., LTD.) with a thickness of 50 µm was directly used.

### (C) Glass sheet-containing substrate

A resin composition composed mainly of epoxy-based resins represented by the following chemical formulas (formula (1) : formula (2) = 50 : 50 (weight ratio)) was sandwiched between two sheets of releasable films subjected to a silicone treatment, and the films were passed through a gap between metal rolls fixed at a 50-µm interval to obtain a laminated body containing an epoxy-based resin layer with a thickness of 30 µm. Next, using an ultraviolet ray irradiation device (conveyor speed: 2.5 m/minute), one side of the laminated body was irradiated with ultraviolet rays (irradiation energy: 250 mJ/cm²) and the epoxy-based resin layer was semi-cured to form a semi-cured layer. Next, one releasable film was removed, and using a laminator, the semi-cured layer of the laminated body was stuck to one face of a sheet of inorganic glass (borosilicate glass available from Matsunami Glass Ind., LTD., thickness: 30 µm). With regard to the other face of the sheet of inorganic glass, the same operation was performed to stick a semi-cured layer thereto. Then, the remaining releasable film was removed, after which the sheet of inorganic glass was irradiated with ultraviolet rays (irradiation energy: 5000 mJ/cm² or more). Afterward, the sheet of inorganic glass was subjected to a heating treatment at 130°C or higher for 10 minutes or more to completely cure the respective semi-cured layers on both faces of the sheet of inorganic glass. In this way, a glass-containing substrate having a laminated structure with a stack of a resin layer of 10 µm/a layer of inorganic glass of 30 µm/a resin layer of 10 µm was obtained.

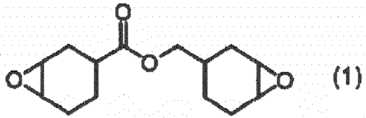

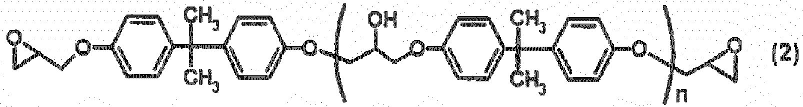

### (D) Resin sheet-containing substrate

As a resin sheet-containing substrate, one prepared by laminating a SiO₂ layer (a barrier layer) with a thickness of 0.3 µm on one face of a polyethylene naphthalate film (available from Teijin DuPont Films Japan Limited) with a thickness of 50 µm by a sputtering method was used. In the case where this resin sheet-containing substrate is used as a sealing substrate, as described below, an adhesive layer was provided on the barrier layer.

### [Tensile modulus of elasticity of substrate]

The tensile moduli of elasticity of the metal sheet-containing substrate, the metal sheet substrate, the glass sheet-containing substrate, and the resin sheet-containing substrate are shown in Table 1.

The tensile moduli of elasticity of the metal sheet-containing substrate and the metal sheet substrate were measured according to JIS Z 2280 (Test method for Young's modulus of metallic materials at elevated temperature), and the tensile moduli of elasticity of the glass sheet-containing substrate and the resin sheet-containing substrate were measured according to JIS K 7127 (Plastics-Determination of tensile properties).

**[Table 1]**

| Substrate used | Tensile modulus of elasticity (GPa) |
|---|---|
| Metal sheet-containing substrate | 193 |
| Metal sheet substrate | 193 |
| Glass sheet-containing substrate | 70 |
| Resin sheet-containing substrate | 6 |

### [Example 1]

In Example 1, as a supporting substrate, the above-mentioned metal sheet-containing substrate was used, and as a sealing substrate, the above-mentioned resin sheet-containing substrate was used. As apparent from Table 1, the tensile modulus of elasticity of the metal sheet-containing substrate is larger than that of the resin sheet-containing substrate. Accordingly, in Example 1, the supporting substrate is a large elasticity substrate, and the sealing substrate is a small elasticity substrate.

### (Element-forming step)

A belt-shaped metal sheet-containing substrate (40 mm in width, 100 m in length) wound into a roll was fed out. On an insulating layer of the metal sheet-containing substrate, an Al layer with a thickness of 100 nm as a first electrode, and among organic layers, an HAT-CN (1,4,5,8,9,12-hexaazatriphenylene hexacarbonitrile) layer with a thickness of 10 nm as a positive hole injection layer, an NPB layer with a thickness of 50 nm as a positive hole transport layer, an Alq₃ layer with a thickness of 45 nm as a light emitting layer and an electron transport layer, and an LiF layer with a thickness of 0.5 nm as an electron injection layer were heated and vapor deposited in this order, after which an Mg/Ag layer with thicknesses of 5/15 nm as a second electrode was co-vapor deposited, and furthermore, an ITO layer with a thickness of 50 nm was deposited by a sputtering method to prepare an element-formed supporting substrate. The element-formed substrate was wound into a roll.

### (Laminating step and winding step)

In the laminating step, a sticking apparatus illustrated in Fig. 5 was used.

As a sealing substrate, a belt-shaped resin sheet-containing substrate (35 mm in width, 100 m in length) in which an uncured epoxy-based thermosetting type adhesive agent layer (an uncured adhesive layer) with a thickness of 10 µm is provided on a barrier layer and a separator is provided on the adhesive agent layer was used.

The element-formed supporting substrate was fed out from the roller 61 to be transported to a gap between the nip rollers for lamination 62, 62. On the other hand, the sealing substrate was fed out from the roller 71, and while peeling off the separator on the way, a sealing substrate having an uncured adhesive layer was transported to a gap between the nip rollers for lamination 62, 62.

The tension of the element-formed supporting substrate and the tension of the sealing substrate before introduced to the nip rollers for lamination 62, 62 were set to 250 N/m and 60 N/m, respectively. In the gap between the nip rollers 62, 62, the sealing substrate was stuck to the element-formed supporting substrate via the uncured adhesive layer, after which the adhesive layer was heated and thermally cured.

In this way, a belt-shaped top emission type organic EL device was prepared, after which the device was wound with the roller 65.

### [Examples 2 to 6, Comparative Examples 1 to 6]

An organic EL device was prepared in the same manner as that in Example 1 except that the tension applied to the element-formed supporting substrate and the tension applied to the sealing substrate were set to respective values listed in Table 2.

### [Examples 7 to 12, Comparative Examples 7 to 12]

An organic EL device was prepared in the same manner as that in Example 1 except that a glass sheet-containing substrate was used as the supporting substrate and each tension was set to a value listed in Table 3.

**[Table 2]**

| | Supporting Substrate | Sealing Substrate | Tension (N/m) | | Luminance Half-Life (hr) |
|---|---|---|---|---|---|
| | | | Supporting Substrate | Sealing Substrate | |
| Example 1 | Metal sheet-containing substrate | Resin sheet-containing substrate | 250 | 60 | 100 |
| Example 2 | Metal sheet-containing substrate | Resin sheet-containing substrate | 250 | 100 | 105 |
| Example 3 | Metal sheet-containing substrate | Resin sheet-containing substrate | 250 | 150 | 110 |
| Example 4 | Metal sheet-containing substrate | Resin sheet-containing substrate | 500 | 60 | 110 |
| Example 5 | Metal sheet-containing substrate | Resin sheet-containing substrate | 500 | 100 | 100 |
| Example 6 | Metal sheet-containing substrate | Resin sheet-containing substrate | 500 | 150 | 95 |
| Comparative Example 1 | Metal sheet-containing substrate | Resin sheet-containing substrate | 250 | 180 | 65 |
| Comparative Example 2 | Metal sheet-containing substrate | Resin sheet-containing substrate | 250 | 200 | 50 |
| Comparative Example 3 | Metal sheet-containing substrate | Resin sheet-containing substrate | 250 | 250 | 30 |
| Comparative Example 4 | Metal sheet-containing substrate | Resin sheet-containing substrate | 500 | 180 | 60 |
| Comparative Example 5 | Metal sheet-containing substrate | Resin sheet-containing substrate | 500 | 200 | 40 |
| Comparative Example 6 | Metal sheet-containing substrate | Resin sheet-containing substrate | 500 | 250 | 25 |

**[Table 3]**

| | Supporting Substrate | Sealing Substrate | Tension (N/m) | | Luminance Half-Life (hr) |
|---|---|---|---|---|---|
| | | | Supporting Substrate | Sealing Substrate | |
| Example 7 | Glass sheet-containing substrate | Resin sheet-containing substrate | 250 | 60 | 100 |
| Example 8 | Glass sheet-containing substrate | Resin sheet-containing substrate | 250 | 100 | 90 |
| Example 9 | Glass sheet-containing substrate | Resin sheet-containing substrate | 250 | 150 | 85 |
| Example 10 | Glass sheet-containing substrate | Resin sheet-containing substrate | 400 | 60 | 90 |
| Example 11 | Glass sheet-containing substrate | Resin sheet-containing substrate | 400 | 100 | 85 |
| Example 12 | Glass sheet-containing substrate | Resin sheet-containing substrate | 400 | 150 | 90 |
| Comparative Example 7 | Glass sheet-containing substrate | Resin sheet-containing substrate | 250 | 180 | 50 |
| Comparative Example 8 | Glass sheet-containing substrate | Resin sheet-containing substrate | 250 | 200 | 40 |
| Comparative Example 9 | Glass sheet-containing substrate | Resin sheet-containing substrate | 250 | 250 | 20 |
| Comparative Example 10 | Glass sheet-containing substrate | Resin sheet-containing substrate | 400 | 180 | 50 |
| Comparative Example 11 | Glass sheet-containing substrate | Resin sheet-containing substrate | 400 | 200 | 35 |
| Comparative Example 12 | Glass sheet-containing substrate | Resin sheet-containing substrate | 400 | 250 | 15 |

### [Example 13]

In Example 13, as a supporting substrate, the above-mentioned resin sheet-containing substrate was used, and as a sealing substrate, the above-mentioned metal sheet substrate was used. As apparent from Table 1, the tensile modulus of elasticity of the resin sheet-containing substrate is smaller than that of the metal sheet substrate. Accordingly, in Example 13, the supporting substrate is a small elasticity substrate, and the sealing substrate is a large elasticity substrate.

### (Element-forming step)

A belt-shaped resin sheet-containing substrate (40 mm in width, 100 m in length) wound into a roll was fed out, and an ITO film with a thickness of 100 nm as a first electrode was formed on a barrier layer of the resin sheet-containing substrate by a sputtering method. On this first electrode, among organic layers, an HAT-CN (1,4,5,8,9,12-hexaazatriphenylene hexacarbonitrile) layer with a thickness of 10 nm as a positive hole injection layer, an NPB layer with a thickness of 50 nm as a positive hole transport layer, an Alq₃ layer with a thickness of 45 nm as a light emitting layer and an electron transport layer, an LiF layer with a thickness of 0.5 nm as an electron injection layer, and an Al layer with a thickness of 100 nm as a second electrode were heated and vapor deposited in this order to prepare an element-formed supporting substrate. The element-formed substrate was wound into a roll.

### (Laminating step and winding step)

In the laminating step, a sticking apparatus illustrated in Fig. 5 was used.

As a sealing substrate, a belt-shaped metal sheet substrate (35 mm in width, 100 m in length) in which an uncured epoxy-based thermosetting type adhesive agent layer (an uncured adhesive layer) with a thickness of 10 µm is provided on its rear face and a separator is provided on the adhesive agent layer was used.

The element-formed supporting substrate was fed out from the roller 61 to be transported to a gap between the nip rollers for lamination 62, 62. On the other hand, the sealing substrate was fed out from the roller 71, and while peeling off the separator on the way, a sealing substrate having an uncured adhesive layer was transported to a gap between the nip rollers for lamination 62, 62.

The tension of the element-formed supporting substrate and the tension of the sealing substrate before introduced to the nip rollers for lamination 62, 62 were set to 60 N/m and 250 N/m, respectively. In the gap between the nip rollers 62, 62, the sealing substrate was stuck to the element-formed supporting substrate via the uncured adhesive layer, after which the adhesive layer was heated and thermally cured.

In this way, a belt-shaped bottom emission type organic EL device was prepared, after which the device was wound with the roller 65.

### [Examples 14 to 18, Comparative Examples 13 to 18]

An organic EL device was prepared in the same manner as that in Example 13 except that the tension applied to the element-formed supporting substrate and the tension applied to the sealing substrate were set to respective values listed in Table 4.

### [Examples 19 to 24, Comparative Examples 19 to 24]

An organic EL device was prepared in the same manner as that in Example 13 except that a glass sheet-containing substrate was used as the sealing substrate and each tension was set to a value listed in Table 5.

**[Table 4]**

| | Supporting Substrate | Sealing Substrate | Tension (N/m) | | Luminance Half-Life (hr) |
|---|---|---|---|---|---|
| | | | Supporting Substrate | Sealing Substrate | |
| Example 13 | Resin sheet-containing substrate | Metal sheet substrate | 60 | 250 | 100 |
| Example 14 | Resin sheet-containing substrate | Metal sheet substrate | 100 | 250 | 100 |
| Example 15 | Resin sheet-containing substrate | Metal sheet substrate | 150 | 250 | 90 |
| Example 16 | Resin sheet-containing substrate | Metal sheet substrate | 60 | 500 | 95 |
| Example 17 | Resin sheet-containing substrate | Metal sheet substrate | 100 | 500 | 90 |
| Example 18 | Resin sheet-containing substrate | Metal sheet substrate | 150 | 500 | 85 |
| Comparative Example 13 | Resin sheet-containing substrate | Metal sheet substrate | 180 | 250 | 55 |
| Comparative Example 14 | Resin sheet-containing substrate | Metal sheet substrate | 200 | 250 | 45 |
| Comparative Example 15 | Resin sheet-containing substrate | Metal sheet substrate | 250 | 250 | 20 |
| Comparative Example 16 | Resin sheet-containing substrate | Metal sheet substrate | 180 | 500 | 50 |
| Comparative Example 17 | Resin sheet-containing substrate | Metal sheet substrate | 200 | 500 | 30 |
| Comparative Example 18 | Resin sheet-containing substrate | Metal sheet substrate | 250 | 500 | 20 |

**[Table 5]**

| | Supporting Substrate | Sealing Substrate | Tension (N/m) | | Luminance Half-Life (hr) |
|---|---|---|---|---|---|
| | | | Supporting Substrate | Sealing Substrate | |
| Example 19 | Resin sheet-containing substrate | Glass sheet-containing substrate | 60 | 250 | 95 |
| Example 20 | Resin sheet-containing substrate | Glass sheet-containing substrate | 100 | 250 | 100 |
| Example 21 | Resin sheet-Resin sheet-containing substrate | Glass sheet-containing substrate | 150 | 250 | 90 |
| Example 22 | Resin sheet-containing substrate | Glass sheet-containing substrate | 60 | 400 | 100 |
| Example 23 | Resin sheet-containing substrate | Glass sheet-containing substrate | 100 | 400 | 90 |
| Example 24 | Resin sheet-containing substrate | Glass sheet-containing substrate | 150 | 400 | 80 |
| Comparative Example 19 | Resin sheet-containing substrate | Glass sheet-containing substrate | 180 | 250 | 50 |
| Comparative Example 20 | Resin sheet-containing substrate | Glass sheet-containing substrate | 200 | 250 | 45 |
| Comparative Example 21 | Resin sheet-containing substrate | Glass sheet-containing substrate | 250 | 250 | 20 |
| Comparative Example 22 | Resin sheet-containing substrate | Glass sheet-containing substrate | 180 | 400 | 50 |
| Comparative Example 23 | Resin sheet-containing substrate | Glass sheet-containing substrate | 200 | 400 | 30 |
| Comparative Example 24 | Resin sheet-containing substrate | Glass sheet-containing substrate | 250 | 400 | 15 |

### [Evaluation of organic EL panel]

Each of the belt-shaped organic EL devices obtained in Examples 1 to 24 and Comparative Examples 1 to 24 above was cut at the boundary part between adjacent organic EL elements under an air atmosphere to obtain an organic EL panel (100 mm in length, 40 mm in width). The organic EL panels obtained in respective examples and respective comparative examples were measured for the luminance half-life described below. The results thereof are shown in respective tables.

### [Measurement of luminance half-life]

With regard to the luminance half-life, a voltage to be applied to each of the organic EL panels was determined so that the initial luminance becomes 1000 cd/m², and at the current value, the time required for the luminance of the panel to fall to half its initial value was measured. The value of the luminance half-life of a top emission type organic EL panel of each of Examples 2 to 12 and Comparative Examples 1 to 12 was a relative value obtained when the luminance half-life of the organic EL panel in Example 1 was defined as 100. Moreover, the value of the luminance half-life of a bottom emission type organic EL panel of each of Examples 14 to 24 and Comparative Examples 13 to 24 was a relative value obtained when the luminance half-life of the organic EL panel in Example 13 was defined as 100.

In Examples 1 to 12, the sealing substrate is a small elasticity substrate and the supporting substrate is a large elasticity substrate, and in Examples 13 to 24, the supporting substrate is a small elasticity substrate and the sealing substrate is a large elasticity substrate. It is found that the organic EL panels of Examples 1 to 24 in which the tension applied to the small elasticity substrate is set to tension less than or equal to 150 N/m have a long luminance half-life as compared with the organic EL panels of Comparative Examples 1 to 24 in which the tension applied to the small elasticity substrate is set to tension greater than or equal to 180 N/m. It is presumed that this is because the internal stress of the substrate generated after the sealing substrate is stuck to the supporting substrate is small.

Moreover, from the results of the examples and the comparative examples, it is presumed that an organic EL device capable of exerting the effects of the present invention can be obtained by setting the tension applied to the small elasticity substrate to tension less than or equal to almost 170 N/m.

Since the tensile modulus of elasticity of the small elasticity substrate used in any of respective examples was 6 GPa and the tension applied thereto was less than or equal to 150 N/m, respective small elasticity substrates were applied with tension having a numerical value less than or equal to 25 times the numerical value of its tensile modulus of elasticity (150 ÷ 6). It is presumed that an organic EL device capable of exerting the effects of the present invention can be obtained by setting the tension applied to the small elasticity substrate having a tensile modulus of elasticity of 6 GPa to a numerical value less than or equal to almost 28 times the numerical value of its modulus of elasticity.

### INDUSTRIAL APPLICABILITY

An organic EL device of the present invention can be used for illuminating devices, image displays, or the like, for example.

1, 10 Organic EL device, 2 Supporting substrate, 3 Organic EL element, 4 Adhesive layer, 5 Sealing substrate, 59 Barrier layer

## Claims

1. A method for producing an organic electroluminescence device using a roll-to-roll method, comprising the step of:
sticking a belt-shaped sealing substrate transported while being applied with tension on a belt-shaped supporting substrate on which an organic electroluminescence element is formed, wherein
either one substrate of the supporting substrate or the sealing substrate has a tensile modulus of elasticity larger than that of another substrate,
in the step, the sticking is performed in the middle of transporting the belt-shaped supporting substrate in the long-side direction while being applied with tension, and
in the step, the substrate having a smaller tensile modulus of elasticity is applied with tension less than or equal to 170 N/m and the substrate having a larger tensile modulus of elasticity is applied with tension greater than the tension applied to the substrate having a smaller tensile modulus of elasticity.

2. A method for producing an organic electroluminescence device using a roll-to-roll method, comprising the step of:
sticking a belt-shaped sealing substrate transported while being applied with tension on a belt-shaped supporting substrate on which an organic electroluminescence element is formed, wherein
either one substrate of the supporting substrate or the sealing substrate has a tensile modulus of elasticity larger than that of another substrate,
in the step, the sticking is performed in the middle of transporting the belt-shaped supporting substrate in the long-side direction while being applied with tension, and
in the step, the substrate having a smaller tensile modulus of elasticity is applied with tension (N/m) having a numerical value less than or equal to 43 times the numerical value of its tensile modulus of elasticity (GPa) and the substrate having a larger tensile modulus of elasticity is applied with tension greater than the tension applied to the substrate having a smaller tensile modulus of elasticity.

3. The method for producing an organic electroluminescence device using a roll-to-roll method according to claim 1 or 2, wherein the tension applied to the substrate having a larger tensile modulus of elasticity is greater than or equal to 200 N/m.

4. The method for producing an organic electroluminescence device using a roll-to-roll method according to any one of claims 1 to 3, wherein a difference in tensile modulus of elasticity between the supporting substrate and the sealing substrate is greater than or equal to 30 GPa.

5. The method for producing an organic electroluminescence device using a roll-to-roll method according to any one of claims 1 to 4, wherein the supporting substrate is the substrate having a larger tensile modulus of elasticity and the sealing substrate is the substrate having a smaller tensile modulus of elasticity.

6. The method for producing an organic electroluminescence device using a roll-to-roll method according to any one of claims 1 to 4, wherein the supporting substrate is the substrate having a smaller tensile modulus of elasticity and the sealing substrate is the substrate having a larger tensile modulus of elasticity.

7. The method for producing an organic electroluminescence device using a roll-to-roll method according to any one of claims 1 to 6, wherein the substrate having a larger tensile modulus of elasticity contains a metal sheet and the substrate having a smaller tensile modulus of elasticity contains a resin sheet.

8. The method for producing an organic electroluminescence device using a roll-to-roll method according to any one of claims 1 to 6, wherein the substrate having a larger tensile modulus of elasticity contains a glass sheet and the substrate having a smaller tensile modulus of elasticity contains a resin sheet.

9. The method for producing an organic electroluminescence device using a roll-to-roll method according to claim 7 or 8, wherein a barrier layer is laminated on the resin sheet.

10. The method for producing an organic electroluminescence device using a roll-to-roll method according to any one of claims 1 to 9, wherein the sealing substrate is stuck on the supporting substrate via an adhesive layer.
